Europäisches Patentamt

European Patent Office

Office européen des brevets

(19)

(11) Veröffentlichungsnummer: **0 191 419**
**B1**

(12) ## EUROPÄISCHE PATENTSCHRIFT

(45) Veröffentlichungstag der Patentschrift: **28.11.90**

(51) Int. Cl.$^5$: **H 01 L 23/427**

(21) Anmeldenummer: **86101543.6**

(22) Anmeldetag: **06.02.86**

(54) Leistungshalbleitermodul mit integriertem Wärmerohr.

(30) Priorität: **14.02.85 DE 3504992**

(43) Veröffentlichungstag der Anmeldung:
**20.08.86 Patentblatt 86/34**

(45) Bekanntmachung des Hinweises auf die
Patenterteilung:
**28.11.90 Patentblatt 90/48**

(84) Benannte Vertragsstaaten:
**CH DE FR GB IT LI NL**

(56) Entgegenhaltungen:
**DE-A-2 825 582
DE-A-3 137 570
FR-A-2 500 959
GB-A-2 039 416
US-A-2 958 021
US-A-4 322 737**

(73) Patentinhaber: **Asea Brown Boveri
Aktiengesellschaft
Kallstadter Strasse 1
D-6800 Mannheim-Käfertal (DE)**

(72) Erfinder: **Wessjohann, Hans Georg, Dr., Dipl.-
Phys.
S6, 29-31
D-6800 Mannheim 1 (DE)**
Erfinder: **Neidig, Arno
Brühlerweg 42
D-6831 Plankstadt (DE)**

(74) Vertreter: **Rupprecht, Klaus, Dipl.-Ing. et al
c/o Asea Brown Boveri Aktiengesellschaft
Zentralbereich Patente Postfach 100351
D-6800 Mannheim 1 (DE)**

## Beschreibung

Die Erfindung bezieht sich auf ein Leistungshalbleiter modul mit integriertem Wärmerohr, mit mindestens einem Leistungshalbleiterbauelement auf einer Trägerplatte aus metallisierter Keramik und mindestens einem im Leistungshalbleitermodul integrierten Wärmerohr zur Verteilung der vom Leistungshalbleiterbauelement abzuführenden Wärme auf eine im Vergleich zur Grundfläche des Leistungshalbleiterbauelements größere Fläche eines Kondensationsbereichs des Wärmerohrs. Dabei handelt es sich um Module mit Leistungshalbleitern, die in Lötkontakttechnik elektrisch isoliert auf einem keramischen Substrat als Trägerplatte aufgebaut sind.

Solche Leistungshalbleitermodule sind aus der EP-A-0 149 786 bekannt, die zum Stand der Technik nach Art. 54(3) EPÜ bezüglich der Ansprüche 1 bis 6 und zum Stand der Technik nach Art. 54(2) bezüglich der Ansprüche 7 bis 12 gehört. Darin wird die Integration eines Wärmerohres im Modul vorgeschlagen zur Verteilung der Verlustwärme eines Leistungshalbleiterbauelementes auf eine größere Substratfläche und damit zur Verbesserung des Wärmetransports vom Leistungshalbleiterbauelement über ein elektrisch isolierendes Substrat zu einer Kühlfläche. Die aus dieser Offenlegungsschrift bekannten Ausführungsformen beziehen sich alle auf eine Integration des Wärmerohrs in die Metallisierung des Substrats. Dabei sind jedoch nur relativ kleine Dampfräume für das Wärmerohr realisierbar, wodurch die Wärmetransportleistung begrenzt ist. Außerdem ist die Herstellung der vorgeschlagenen feinen Strukturen für Kapillaren und Dampfräume nicht ganz einfach.

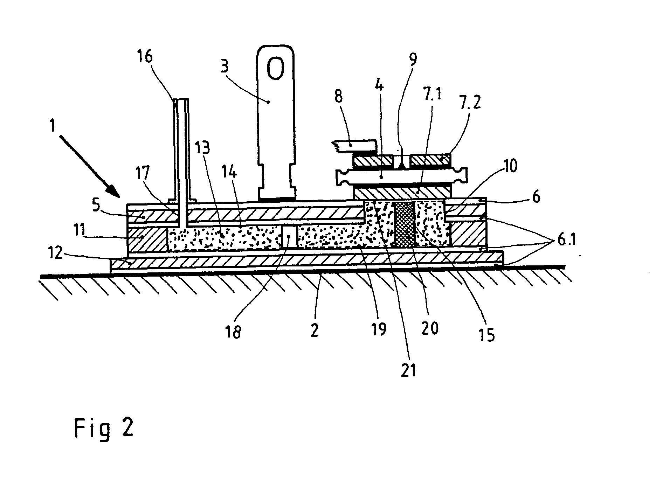

Aus der UK 20 39 416 ist ein Leistungshalbleitermodul mit einem Wärmerohr bekannt, das einen ausreichend großen Dampfraum aufweist. In Fig. 2 ist dort eine Ausführung dargestellt, bei der ein keramisches Substrat mit Hohlräumen versehen und als Wärmerohr ausgestaltet ist. Allerdings ist dabei der Wärmetransport von Halbleiterbauelementen durch eine keramische Schicht in den Dampfraum erforderlich. Eine bessere thermische Kopplung zwischen Halbleiterbauelementen und dem Dampfraum eines Wärmerohres ergibt sich bei der Ausführung gemäß Fig. 5. Bei dieser Ausführung sind Bohrungen in der Keramik vorgesehen, in die Halbleiterbauelemente eingesetzt sind und somit in direktem Kontakt zum Dampfraum des Wärmerohrs stehen. Aber auch dieses Konzept hat noch einige Nachteile, insbesondere bezüglich der praktischen Realisierbarkeit eines Moduls mit ausreichend langer LebensdauerMit den angegebenen Mitteln zur Verbindung der Halbleiterbauelemente mit dem Substrat und den genannten Arbeitsflüssigkeiten ist beispielsweise keine Werkstoffkombination möglich, die nicht nach kurzer Zeit zur Korrosion führen würde. Außerdem ist durch den Wärmetransport zu einem Ende des Wärmerohres keine gute Wärmespreizung gegeben.

Ausgehend von diesem Stand der Technik liegt der vorliegenden Erfindung die Aufgabe zugrunde, eine Ausführungsvariante für ein Leistungshalbleitermodul mit integriertem Wärmerohr anzugeben, die einen großen Dampfraum des Wärmerohrs ermöglicht, einfach herstellbar ist und hinsichtlich der Korrosion im Wärmerohr verbessert ist.

Diese Aufgabe wird bei einem Leistungs halbleitermodul gemäß dem Anspruch 1 gelöst.

Vorteile der Erfindung bestehen u.a. darin, daß das Leistungshalbleitermodul mit integriertem Wärmerohr auf einfache Weise durch Zusammensetzen handelsüblicher Teile, nämlich von Keramiksubstraten hergestellt werden kann und daß das Modul in gleicher Weise wie Module ohne Wärmerohr handhabbar ist. Alle Teile des Wärmerohres, die mit der Arbeitsflüssigkeit in Berührung kommen, können aus Keramik oder Kupfer hergestellt werden bzw. mit Kupfer beschichtet werden, so daß keine Korrosionsprobleme zu erwarten sind. Nach einer vorteilhaften Ausgestaltung kann eine Kapillarstruktur vorgesehen werden, wodurch das Modul in beliebiger Einbaulage betrieben werden kann. Die erforderliche vakuumdichte Verbindung zwischen Keramik und Kupferteilen bzw. zwischen Kupferflächen kann vorteilhaft durch sogenanntes direktes Verbinden hergestellt werden. Nach einer weiteren vorteilhaften Ausgestaltung kann zur besseren Wärmeverteilung in der Heizzone des Wärmerohres ein spezieller Heizer vorgesehen werden.

Weitere Vorteile ergeben sich aus den Unteransprüchen und der nachstehenden Beschreibung von Ausführungsbeispielen anhand der Zeichnung.

Es zeigen:

Fig. 1 Leistungshalbleitermodul mit einem Wärmerohr ohne Kapillarstruktur (Schwerkraft-Wärmerohr),

Fig. 2 Leistungshalbleitermodul mit einem Wärmerohr, das eine Kapillarstruktur enthält,

Fig. 3 Leistungshalbleitermodul mit Wärmerohr, in dessen Heizzone ein spezieller Heizer angeordnet ist.

Wärmerohre (heat-pipes) sind allgemein bekannt und sind z.B. in den BBC-Nachrichten, 1966, Seite 206 bis 211 beschrieben. Es handelt sich dabei um einen geschlossenen Raum, der teilweise mit einer Flüssigkeit gefüllt ist. Das Wandmaterial und die Art der Flüssigkeit hängen im wesentlichen vom Temperaturbereich ab, in dem das Wärmerohr arbeiten soll. Bei Wärmezufuhr an einer Stelle des Wärmerohres (Heizzone) verdampft die Flüssigkeit und der Dampf verteilt sich über den gesamten Innenraum. An einer Wärmesenke kondensiert der Dampf und gibt dabei Wärme ab. Die Arbeitsflüssigkeit muß zur Heizzone zurück transportiert werden. Dies kann mit Hilfe der Schwerkraft geschehen, wenn man das Wärmerohr so anordnet, daß die Heizzone unten und die Wärmesenke weiter oben ist. Der Rücktransport der Flüssigkeit kann jedoch auch durch Kapillarkraft erfolgen, wozu die Innenwand mit Rillen, Netzen oder einer porösen Schicht versehen wird. Das Wärmerohr zeichnet sich dadurch aus, daß die Wärme von einer Wärmequelle zu einer weiter entfernten und/oder großflächigen Wärmesenke bei nur geringem Temperaturabfall transportiert werden kann. Die von dem sogenannten Wärmerohr gebildete Kammer muß keineswegs zylindrisch sein; ein Wärmerohr kann eine nahezu beliebige Form haben.

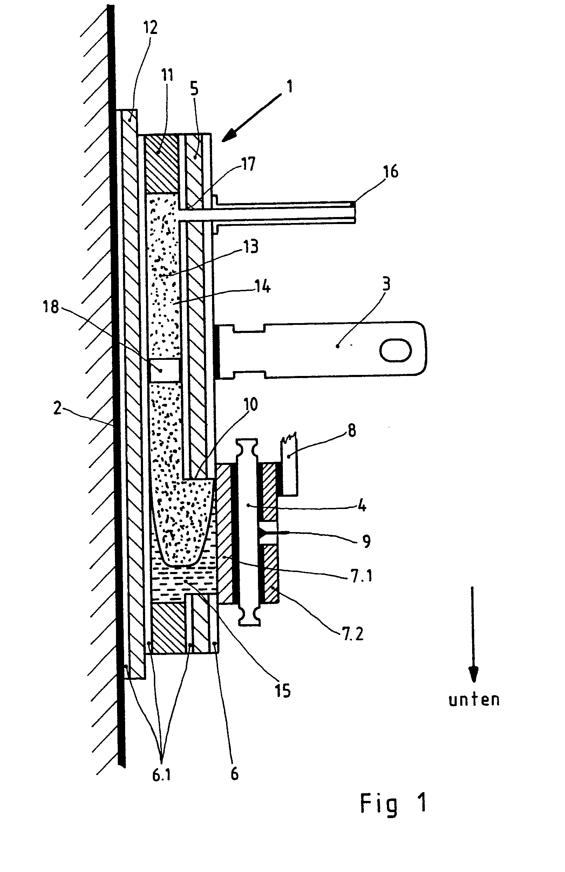

Leistungshalbleitermodule werden häufig in einer definierten Einbaulage betrieben, z.B. an einer senkrechten Wand in einem Schaltschrank. In solchen Fällen kann ein Leistungshalbleitermodul mit einem Schwerkraft-Wärmerohr eingesetzt werden, wie in Fig. 1 dargestellt.

Fig. 1 zeigt ein Leistungshalbleitermodul 1, das regelmäßig mit einem nicht dargestellten Kunststoffgehäuse versehen und auf einen Kühlkörper 2 als Wärmesenke montiert ist. Anschlußelemente 3, Leistungshalbleiterbauelemente 4 und ggf. sonstige nicht dargestellte Bauelemente sind auf einer Trägerplatte 5 aufgelötet. Bei der Trägerplatte 5 handelt es sich um eine metallisierte Keramikplatte. Die Trägerplatte 5 braucht nicht besonders gut wärmeleitend zu sein und kann deshalb vorzugsweise aus einer ca. 1 bis 2 mm dicken $Al_2O_3$-Keramik geringer Reinheit (z.B. $Al_2O_3$-Anteil unter 96%) hergestellt sein. Auf der den Bestückungselementen 3, 4 zugewandten Oberseite hat die Trägerplatte 5 eine entsprechend der gewünschten Schaltung strukturierte Metallisierung 6 aus Kupfer mit einer Schichtdicke von z.B. 0,3 bis 0,5 mm. Da die Trägerplatte 5 nicht besonders gut wärmeleitend sein muß, kann sie aus einer relativ dicken Keramikplatte bestehen, die auch eine relativ dicke Kupferschicht, nämlich die strukturierte Metallisierung 6 tragen kann. Dies kann bei hohen Stromstärken besonders vorteilhaft sein, da die strukturierte Metallisierung 6 auf der Oberseite der Trägerplatte 5 die Leiterbahnen eines Schaltkreises bildet.

Leistungshalbleiterbauelemente 4 sind nicht direkt auf die Metallisierung 6 der Trägerplatte 5 aufgelötet, sondern in üblicher Weise mit Ronden 7.1, 7.2 aus Molybdän als Abstands- und Ausgleichsronden versehen. Die obere Ausgleichsronde 7.2 trägt einen Kathodenanschluß 8 und hat eine Bohrung im Bereich eines Gate-Anschlusses 9. Die untere Ausgleichsronde 7.1 deckt eine Öffnung 10 in der Trägerplatte 5 ab. Eine oder mehrere solcher Öffnungen 10 sind in der Nähe der — im eingebauten Zustand des Moduls 1 — unteren Kante der Trägerplatte 5 angeordnet. Je nach der Form der Leistungshalbleiterbauelemente 4 bzw. der Ausgleichsronden 7.1 kann die Form der Öffnung rund oder rechteckig sein. Die Öffnung 10 wird um z.B. 1 mm kleiner als die Ausgleichsronde 7.1 ausgeführt.

Über einen Rahmen 11 ist die Trägerplatte 5 mit einer Grundplatte 12 verbunden. Die Dicke des Rahmens 11 zwischen der Trägerplatte 5 und der Grundplatte 12 richtet sich nach der Dimensionierung des Dampfraums 13 des Wärmerohrs 14. Je dicker der Rahmen 11 gewählt wird, desto größer wird der Dampfraum 13 und damit die Wärmetransportleistung des Wärmerohres 14. Wie Versuche mit einem Modul gezeigt haben, dessen Grundplatte 12 die Fläche 70 x 100 mm hatte, reicht eine Dicke des Rahmens 11 von 1 bis 2 mm aus, um Verlustleistungen von einigen Hundert Watt gleichmäßig über das Wärmerohr 14 zu verteilen. Der Rahmen 11 kann aus dem gleichen keramischen Material mit geringer Reinheit bestehen, wie die Trägerplatte 5. Der Rahmen 11 kann aber auch aus Metall mit geeigneter Wärmeausdehnung bestehen, z.B. aus einem ca. 1 mm dicken Kupferblech, das nachgiebig genug ist, um die Wärmedehnungsunterschiede aufzufangen, aber stark genug, um gegen den äußeren Druck abzustützen.

Die Grundplatte 12 muß gut wärmeleitend sein und muß elektrisch isolieren. Sie besteht aus einer hochreinen $Al_2O_3$-Keramik (mindestens 96% $Al_2O_3$, z.B. 99,5% $Al_2O_3$) und ist typisch 0,64 mm dick. Sie ist beidseitig mit einer Metallisierung 6.1 aus Kupferblech mit ca. 0,2 bis 0,3 mm Dicke versehen. Auf der dem Kühlkörper 2 abgewandten Seite ist die Metallisierung 6.1 etwa 1 bis 2 mm vom Rand der Grundplatte 12 zurückgesetzt, um eine ausreichende Isolationsstrecke zur elektrischen Isolierung zu gewährleisten.

Alle Verbindungen zwischen den Metallisierungen 6, 6.1 und den keramischen Platten 5, 12 sowie der Platten 5, 12 mit dem Rahmen 11 untereinander, werden zweckmäßig durch direktes Verbinden (direct bonding) hergestellt.

Dazu muß auch zwischen dem Rahmen 11 und der Trägerplatte 5 eine Metallisierung 6.1 vorhanden sein, die entweder auf der Trägerplatte 5 oder auf dem Rahmen 11 vorzusehen ist. Es können auch sowohl die Trägerplatte 5 als auch der Rahmen 11 beidseitig metallisiert sein, da sich zwei Metallisierungen 6.1 gut miteinander verbinden. Es kann zweckmäßig sein, auf der Unterseite der Trägerplatte 5 eine ganzflächige Metallisierung vorzusehen. Dies richtet sich danach wie sich die gesamte Anordnung von Platten 5 und 12 und des Rahmens 11 nach der Fertigstellung als Folge von mechanischen Spannungen wölbt. Vorteilhaft stellt man eine zum Kühlkörper 2 hin leicht konvexe Wölbung der Grundplatte 12 ein. Diese Wölbung kann auch durch die Dicke der Metallisierungen 6.1 auf der Grundplatte 12 beeinflußt werden. Das hier angesprochene Direct Bonding-Verfahren ist allgemein bekannt und z.B. in der DE-PS 30 36 128 beschrieben.

Der für das Wärmerohr 14 erforderliche Dampfraum 13 wird wie bereits dargestellt, durch die Platten 5 und 12, den Rahmen 11 und die unteren Ausgleichsronden 7.1 unter den Leistungshalbleiterbauelementen 4 gebildet. Die Verbindungen zwischen diesen Teilen müssen vakuumdicht hergestellt werden. Zur Vervollständigung des Wärmerohrs 14 ist etwas Arbeitsflüssigkeit 15 (z.B. Wasser) erforderlich, die über ein Einfüllröhrchen 16 aus Kupfer eingefüllt wird, das über einer Bohrung 17 in der Trägerplatte 15 aufgesetzt und mit dessen strukturierter Metallisierung 6 direkt verbunden ist (durch direktes Verbinden).

Die Arbeitsflüssigkeit 15 sammelt sich bei der vorgesehenen Einbaulage unter Einwirkung der Schwerkraft im Bereich der unteren Ausgleichsronde 7.1 an und benetzt diese aufgrund des Füllstandes bzw. durch Adhäsion und Kapillarwirkung wie in Fig. 1 angedeutet. Durch die Verlustwärme des Leistungshalbleiterbauelements 4, die über die untere Ausgleichsronde 7.1 der Arbeitsflüssigkeit zugeführt wird, verdampft diese. Der Dampf breitet sich im gesamten Dampfraum 13 aus, kondensiert an der gekühlten Grundplatte 12 (Kondensationsbereich) und fließt zurück zur Heizzone.

Weitere Einzelheiten zum erfindungsgemäßen Leistungshalbleitermodul ergeben sich aus der nachstehenden Beschreibung einer Möglichkeit zur Herstellung des Moduls.

Zunächst werden die Trägerplatte 5 (mit den Löchern 10,17) und die Grundplatte 12 beidseitig mit Kupfer beschichtet zur Herstellung der Metallisierungen 6.1 bzw. der strukturierten Metallisierung 6 auf der Oberseite der Platte 5. Nach entsprechender Gestaltung der Metallisierungen 6 bzw. 6.1 auf der Oberseite der Platte 5 bzw. 12 werden die unteren Ausgleichsronden 7.1 mit Kupfer beschichtet zur Vorbereitung eines Verbindungsprozesses, bei dem die unteren Ausgleichsronden 7.1 und das Einfüllröhrchen 16 durch direktes Verbinden auf der Oberseite der Trägerplatte 5 aufgebracht werden. Dies wird als günstiger erachtet, als eine Montage dieser Teile durch Weichlöten, weil bei weichgelöteten Teilen Korrosionsprobleme durch die Arbeitsflüssigkeit 15 (deionisiertes Wasser) hervorgerufen werden könnten.

Anschließend werden die Grundplatte 12, der Rahmen 11 und die vorbestückte Trägerplatte 5 übereinander geschichtet zur Vorbereitung des nächsten Verbindungsprozesses. Zur Erhöhung der Stabilität, insbesondere im Hinblick auf den späteren evakuierten Zustand, können dabei vorteilhaft Abstandstücke 18 aus einem geeigneten Material in dem Raum zwischen der Trägerplatte 5 und der Grundplatte 12 eingesetzt werden. Diese Abstandstücke 18 können z.B. an den Rahmen 11 angeformt sein. Es folgt der Verbindungsprozeß (direct bonding) und anschließend werden die außen liegenden Kupferflächen stromlos (chemisch) vernickelt zur Vorbereitung der folgenden Weichlötprozesse, bei denen die Struktur mit dem integrierten Wärmerohr 14 wie ein übliches metallisiertes Keramiksubstrat behandelt wird. Das heißt es werden Leistungshalbleiterbauelemente 4, obere Ausgleichsronden 7.2, Anschlüsse 3,8 und sonstige Teile aufgelötet und eine Kunststoffkapselung vorgenommen. In das Wärmerohr 14 wird über das Einfüllröhrchen 16 etwas Arbeitsflüssigkeit 15, z.B. Wasser, eingefüllt, der Dampfraum 13 auf etwa 2000 bis 3000 Pa abgepumpt und das Einfüllröhrchen 16 vakuumdicht abgequetscht.

Mit einem solchen erfindungsgemäßen Modul 1 mit einem Leistungshalbleiterbauelement (Thyristor) mit 25 mm Durchmesser der Anodenkontaktfläche und einer Öffnung 10 mit 21 mm Durchmesser in der Trägerplatte 5 wurde in Versuchen ein Gleichstrom-Wärmewiderstand zwischen dem Aktivteil (Junction) des Leistungshalbleiterbauelements 4 und dem Kühlkörper 2 von $R_{thJK} = 0{,}06$ K/W erreicht. Dieser Wert entspricht etwa einer entsprechenden doppelseitig gekühlten Scheibenzelle bei nicht isoliertem Aufbau. Um den erreichten Fortschritt zu ermessen ist der genannte Wärmewiderstandswert zu vergleichen mit einem Wärmewiderstand von etwa 0,15 K/W für das gleiche Bauelement bei isoliertem Aufbau (Keramikplatte 0,64 mm dick aus $Al_2O_3$ mit 99,5% Reinheit) jedoch ohne integriertes Wärmerohr.

Fig. 2 zeigt eine erfindungsgemäße Ausgestaltung des Leistungshalbleitermoduls 1, bei der die Einbaulage beliebig sein kann, die also unabhängig ist von der Schwerkraft. Dies wird durch eine Kapillarstruktur 19, 20, 21 erreicht, mit deren Hilfe die kondensierte Arbeitsflüssigkeit 15 zur Heizzone, d.h. zur unteren Ausgleichsronde 7.1 durch Kapillarkräfte zurücktransportiert wird.

Zur Herstellung der Kapillarstruktur 19, 20, 21 wird vor dem Zusammenbau der Trägerplatte 5 des Rahmens 11 und der Grundplatte 12 ein feinmaschiges Netz 19 aus Kupferdraht auf der dem Kühlkörper 2 abgewandten Seite der Grundplatte 12 aufgelegt. Außerdem wird zentral unter der unteren Ausgleichsronde 7.1 ein poröses Sinterpreßteil 20 aus Kupfer oder Keramik mit einem Durchmesser von etwa 5 mm und dem Abstand von Grundplatte 12 mit Ausgleichsronde 7.1 entsprechender Höhe eingesetzt. Diese Teile 19, 20 werden durch direktes Verbinden befestigt. Die untere Ausgleichsronde 7.1 weist ihrerseits auf der dem Innenraum des Wärmerohrs 14 zugewandten Seite ein Kapillarsystem 21 auf, das knapp bis zum Rand der Öffnung 10 in der Trägerplatte 5 reicht.

Selbstverständlich bieten sich dem Fachmann eine Vielzahl weiterer Möglichkeiten zur Realisierung einer Kapillarstruktur, die hier nicht aufgeführt werden müssen. Beispielsweise können statt Kupferdrahtnetzen 19 auch Rillen in der Metallisierung 6.1 vorgesehen werden.

Durch inhomogene Stromführung innerhalb des Leistungshalbleiterbauelementes 4 (sogenannte Schieflast) kann es zu einer ungleichmäßigen Wärmeerzeugung im Leistungshalbleiterbauelement 4 kommen. In einem solchen Fall ist die Temperaturverteilung an der Übergangsfläche von der unteren Ausgleichsronde 7.1 — die üblicherweise aus Molybdän besteht — zur Arbeitsflüssigkeit 15 inhomogen. Die Wärmeleitfähigkeit des Molybdäns reicht nämlich nicht aus um den Wärmestrom aus dem Leistungshalbleiterbauelement 4 auf die gesamte Fläche der Ausgleichsronde 7.1 zu verteilen. Dadurch können sogenannte Heißstellen in der Heizzone auftreten, die bewirken, daß sogenanntes Filmsieden auftritt, wodurch diese Heißstellen austrocknen und weiter überhitzt werden, während an den kühleren Stellen die Siedetemperatur für das für eine gute Wärmeabfuhr erwünschte Blasensieden nicht erreicht wird. Durch diesen Vorgang wird die effektive Heizzone vermindert.

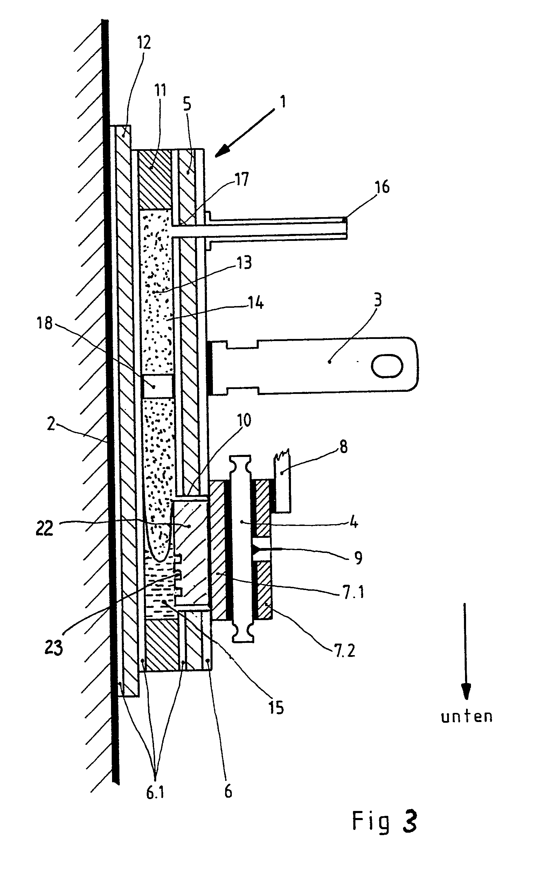

Abhilfe kann nach einer in Fig. 3 dargestellten vorteilhaften Ausgestaltung dadurch geschaffen werden, daß ein spezieller Heizer 22 vorgesehen wird, der in der Heizzone angeordnet ist. Der Heizer 22 besteht aus einem gut wärmeleitenden Material, z.B. Kupfer, und verteilt die im Leistungshalbleiterbauelement 4 erzeugte Wärme durch Wärmespreizung auf eine größere Fläche.

Der vorgeschlagene Heizer 22 ist in der in Fig. 1 und 3 dargestellten Ausführung des Wärmerohrs 14 ohne Kapillarstruktur 19 besonders wirkungsvoll, kann aber grundsätzlich auch bei Verwendung eines Wärmerohrs 14 mit Kapillarstruktur 19 angewendet werden.

Die Anwendbarkeit des vorgeschlagenen Heizers 22 ist darüberhinaus nicht auf den mit der vorliegenden Erfindung vorgeschlagenen speziellen Aufbau des Moduls beschränkt. Der Heizer 22 kann in allen Leistungshalbleitermodulen mit integriertem Wärmerohr 14 vorgesehen werden, in denen ein Leistungshalbleiterbauelement 4 direkt oder über Zwischenschichten mit dem Dampfraum 13 des Wärmerohrs 14 in Verbindung steht.

Der Heizer 22 kann mit der unteren Ausgleichsronde 7.1 verlötet sein. Wenn ein bezüglich des thermischen Ausdehnungskoeffizienten an das Leistungshalbleiterbauelement 4, d.h. an Silizium angepaßten Werkstoff für den Heizer 22 gewählt wird, kann als Ausgleichsronde und Heizer vorteilhaft ein integriertes Bauteil vorgesehen werden, z.B. aus einem Sintermetall, wie Kupfer-Molybdän, das selbst direkt mit der Kupferschicht 6 vakuumdicht verbunden werden kann.

Zur Vergrößerung der Kontaktfläche zwischen Heizer 22 und Arbeitsflüssigkeit 15 kann der Heizer 22 auf der dem Dampfraum 13 zugewandten Seite mit einer Finnenstruktur 23, z.B. Rillen, versehen werden.

## Patentansprüche

1. Leistungshalbleitermodul mit
mindestens einem Leistungshalbleiterbauelement auf einer Trägerplatte aus metallisierter Keramik und
mindestens einem im Leistungshalbleitermodul integrierten Wärmerohr zur Verteilung der vom Leistungshalbleiterbauelement abzuführenden Wärme auf eine im Vergleich zur Grundfläche des Leistungshalbleiterbauelements größere Fläche eines Kondensationsbereichs des Wärmerohrs, wobei
eine gut wärmeleitende Grundplatte (12) aus beidseitig metallisierter Keramik vorgesehen ist, die über einen Rahmen (11) mit der Trägerplatte (5) zur Bildung eines Dampfraums (13) des Wärmerohrs (14) vakuumdicht verbunden ist, und
die Trägerplatte (5) im Bereich unterhalb des Leistungshalbleiterbauelements (4) bzw. einer zwischengefügten Ausgleichsronde (7.1) eine Öffnung (10) aufweist.

2. Leistungshalbleitermodul nach Anspruch 1, dadurch gekennzeichnet, daß innerhalb des Wärmerohrs (14) eine Kapillarstruktur (19, 20, 21) angeordnet ist, für den Rücktransport einer Arbeitsflüssigkeit (15) zu einer Heizzone unterhalb des Leistungshalbleiterbauelements (4).

3. Leistungshalbleitermodul nach Anspruch 1 oder 2, dadurch gekennzeichnet, daß zwischen der Trägerplatte (5) und der Grundplatte (12) Abstützelemente (18) angeordnet sind.

4. Leistungshalbleitermodul nach einem der Ansprüche 1 bis 3, dadurch gekennzeichnet, daß die Teile (5, 7.1, 11, 12) zur Bildung der Wand des Wärmerohrs (14) durch einen oder mehrere Direct-Bonding-prozesse miteinander verbunden sind.

5. Leistungshalbleitermodul nach einem der Ansprüche 1 bis 4, dadurch gekennzeichnet, daß alle mit der Arbeitsflüssigkeit (15) in Berührung kommende Teile (5, 7.1, 11, 12, 16, 18 bis 21) des Wärmerohrs (14) aus Keramik oder Kupfer bestehen bzw. mit Kupfer beschichtet sind.

6. Leistungshalbleitermodul nach einem der Ansprüche 1 bis 5, dadurch gekennzeichnet, daß die gut wärmeleitende Grundplatte (12) aus einer Keramik mit einer Reinheit von mindestens 96% $Al_2O_3$, bevorzugt 99,5% $Al_2O_3$, hergestellt ist.

7. Leistungshalbleitermodul nach einem der vorstehenden Ansprüche, dadurch gekennzeichnet, daß in der Heizzone des Wärmerohrs (14) ein Heizer (22) aus gut wärmeleitendem Material angeordnet ist.

8. Leistungshalbleitermodul nach Anspruch 7, dadurch gekennzeichnet, daß der Heizer auf seiner dem Dampfraum (13) zugewandten Seite mit einer Finnenstruktur (23) versehen ist.

9. Leistungshalbleitermodul nach Anspruch 7 oder 8, dadurch gekennzeichnet, daß der Heizer (22) aus Kupfer besteht.

10. Leistungshalbleitermodul nach Anspruch 7 bis 9, dadurch gekennzeichnet, daß der Heizer (22) mit der Ausgleichsronde (7.1) verlötet ist.

11. Leistungshalbleitermodul nach Anspruch 7 bis 9, dadurch gekennzeichnet, daß der Heizer (22) und die Ausgleichsronde (7.1) in einem Bauteil zusammengefaßt sind und aus einem bezüglich des thermischen Ausdehnungskoeffizienten an das Leistungshalbleiterbauelement (4) angepaßten Werkstoff besteht.

12. Leistungshalbleitermodul nach einem der vorstehenden Ansprüche, dadurch gekennzeichnet, daß die Grundplatte (12) mit einem Kühlkörper (2) verbunden ist.

## Revendications

1. Module semi-conducteur de puissance comprenant
au moins un composant semi-conducteur de puissance sur une plaque de support en céramique métallisée et
au moins un caloduc, intégré dans le module semi-conducteur de puissance, pour la répartition de la chaleur, devant être évacuée du composant semi-conducteur de puissance, sur une surface d'une zone de condensation du caloduc, qui est plus grande que la surface de base du composant semi-conducteur de puissance,
une plaque de base (12), bonne thermoconduc- trice, en céramique métallisée sur les deux faces étant reliée de façon étanche au vide par un cadre (11) à la plaque de support (5), en vue de former une chambre à vapeur (13) du caloduc (14), et

la plaque de support (5) présentant une ouverture (10) audessous du composant semi-conducteur de puissance (4) ou d'un disque de compensation (7.1) intercalé.

2. Module semi-conducteur de puissance selon la revendication 1, caractérisé par le fait qu'une structure capillaire (19, 20, 21) est disposée à l'intérieur du caloduc (14) en vue du transport de retour d'un liquide de travail (15) vers une zone de chauffage se trouvant au-dessous du composant semi-conducteur de puissance (4).

3. Module semi-conducteur de puissance selon revendication 1 ou 2, caractérisé par le fait que des éléments d'appui (18) sont prévus entre la plaque de support (5) et la plaque de base (12).

4. Module semi-conducteur de puissance selon l'une des revendications 1 à 3, caractérisé par le fait que les parties (5, 7.1, 11, 12) pour former la paroi du caloduc (14) sont reliées les unes aux autres par un ou plusieurs procédés de liaison directe.

5. Module semi-conducteur de puissance selon l'une des revendications 1 à 4, caractérisé par le fait que toutes les parties (5, 7.1, 11, 12, 16, 18 à 21) du caloduc (14) en contact avec le liquide de travail (15) sont en céramique ou en cuivre ou sont recouvertes de cuivre.

6. Module semi-conducteur de puissance selon l'une des revendications 1 à 5, caractérisé par le fait que la plaque de base (12) bonne thermoconductrice est fabriquée en céramique avec une pureté d'au moins 96% de $Al_2O_3$, de préférence 99,5% de $Al_2O_3$.

7. Module semi-conducteur de puissance selon l'une des revendications précédentes, caractérisé par le fait qu'un chauffage (22) en matériau bon thermoconducteur est disposé dans la zone de chauffage du caloduc (14).

8. Module semi-conducteur de puissance selon la revendication 7, caractérisé par le fait que le chauffage est pourvu, sur son côté tourné vers la chambre à vapeur (13), d'une structure crénelée.

9. Module semi-conducteur de puissance selon revendication 7 ou 8, caractérisé par le fait que le chauffage (22) est en cuivre.

10. Module semi-conducteur de puissance selon revendications 7 à 9, caractérisé par le fait que le chauffage (22) est soudé au disque de compensation (7.1).

11. Module semi-conducteur de puissance selon revendications 7 à 9, caractérisé par le fait que le chauffage (22) et le disque de compensation (7.1) sont réunis dans un composant qui est constitué par un matériau adapté au composant semi-conducteur de puissance (4) en ce qui concerne le coefficient de dilatation thermique.

12. Module semi-conducteur de puissance selon l'une des revendications précédentes, caractérisé par le fait que la plaque de base (12) est reliée à un corps de refroidissement (2).

Claims

1. Power semiconductor module comprising
at least one power semiconductor component on a carrier plate of metallized ceramic and
at least one heat pipe integrated in the power semiconductor module for distributing the heat to be removed from the power semiconductor component over an area, which is larger than the base area of the power semiconductor component, of a condensation region of the heat pipe, in which
a base plate (12) of ceramic metallized on both sides and having good thermal conduction is provided which is bonded in a vacuum-tight manner via a frame (11) to the carrier plate (5) to form a vapour space (13) of the heat pipe (14), and
the carrier plate (5) has an opening (10) in the region beneath the power semiconductor component (4) or an interposed compensation disc (7.1).

2. Power semiconductor module according to Claim 1, characterized in that a capillary structure (19, 20, 21) for transporting a working liquid (15) back to a heating zone beneath the power semiconductor component (4) is disposed inside the heat pipe (14).

3. Power semiconductor module according to Claim 1 or 2, characterized in that support elements (18) are disposed between the carrier plate (5) and the base plate (12).

4. Power semiconductor module according to one of Claims 1 to 3, characterized in that the parts (5, 7.1, 11, 12) are bonded together to form the wall of the heat pipe (14) by one or more direct bonding processes.

5. Power semiconductor module according to one of Claims 1 to 4, characterized in that all the parts (5, 7.1, 11, 12, 16, 18 to 21) of the heat pipe (14) which come into contact with the working liquid (15) are composed of ceramic or copper or are coated with copper.

6. Power semiconductor module according to one of Claims 1 to 5, characterized in that the base plate (12) with good thermal conduction is produced from a ceramic having a purity of not less than 96% $Al_2O_3$, preferably 99.5% $Al_2O_3$.

7. Power semiconductor module according to one of the preceding claims, characterized in that the heater (22) made of a material with good thermal conduction is disposed in the heating zone of the heat pipe (14).

8. Power semiconductor module according to Claim 7, characterized in that the heater is provided with a fin structure (23) on its side facing the vapour space (13).

9. Power semiconductor module according to Claim 7 or 8, characterized in that the heater (22) is composed of copper.

10. Power semiconductor module according to Claims 7 to 9, characterized in that the heater (22) is soldered to the compensation disc (7.1).

11. Power semiconductor module according to Claims 7 to 9, characterized in that the heater (22) and the compensation disc (7.1) are combined as one structural member and is [sic] composed of a material which is matched to the power semiconductor component (4) in relation to the coefficient of thermal expansion.

12. Power semiconductor module according to one of the preceding claims, characterized in that the base plate (12) is bonded to a cooling body (2).

Fig 1

unten

EP 0 191 419 B1

Fig 2

2

EP 0 191 419 B1

Fig 3

unten

3